# EUROPEAN PATENT APPLICATION

(11) **EP 3 373 349 A1**
(43) Date of publication of application: **12.09.2018**
(21) Application number: 17159414.6
(22) Date of filing: 06.03.2017
(51) Int. Cl.: H01L 41/193

(54) **ACTUATOR, DEVICE AND ACTUATION METHOD**

(71) Applicant: Koninklijke Philips N.V., 5656 AE Eindhoven (NL)
(72) Inventor: PELSSERS, Eduard Gerard Marie, 5656 AE Eindhoven (NL); VAN DE MOLENGRAAF, Roland Alexander, 5656 AE Eindhoven (NL); VAN DEN ENDE, Daan Anton, 5656 AE Eindhoven (NL); HORIKX, Jeroen Jan Lambertus, 5656 AE Eindhoven (NL); JOHNSON, Mark Thomas, 5656 AE Eindhoven (NL)
(74) Representative: de Haan, Poul Erik

(57) **Abstract**

An actuator comprises an electroactive material disposed in a gap between electrodes. The electroactive material is capable of deforming in response to an electrical stimulus such that the gap narrows towards a minimum electrode spacing. The electroactive material comprises an electroactive polymer having a first Young's modulus, and particles dispersed in the electroactive polymer. The particles have a second Young's modulus which is higher than the first Young's modulus, and occupy a volume fraction in a range of 13-35% of the electroactive material. The particles determine the minimum electrode spacing.

## Description

### FIELD OF THE INVENTION

This invention relates to an actuator, in particular an actuator comprising an electroactive material.

### BACKGROUND OF THE INVENTION

Electroactive materials (EAMs), and in particular electroactive polymers (EAPs) are an emerging class of materials within the field of electrically responsive materials. EAPs can work as sensors or actuators and can easily be manufactured into various shapes allowing straightforward integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, a large range of possible actuation frequencies (e.g. up to 1 MHz), and cyclic actuation. Most typically actuation frequencies are below 20 kHz.

The improved performance and particular advantages of EAP materials give rise to applicability to new applications.

An EAP device can be used in any application in which a small amount of movement of a component or feature is desired, based on electric actuation. Similarly, the technology can be used for sensing small movements.

The use of EAPs enables functions which were not possible before, or offers a significant advantage over common sensor/actuator solutions, due to the combination of a relatively large deformation and force in a small volume or thin form factor, compared to common actuators.

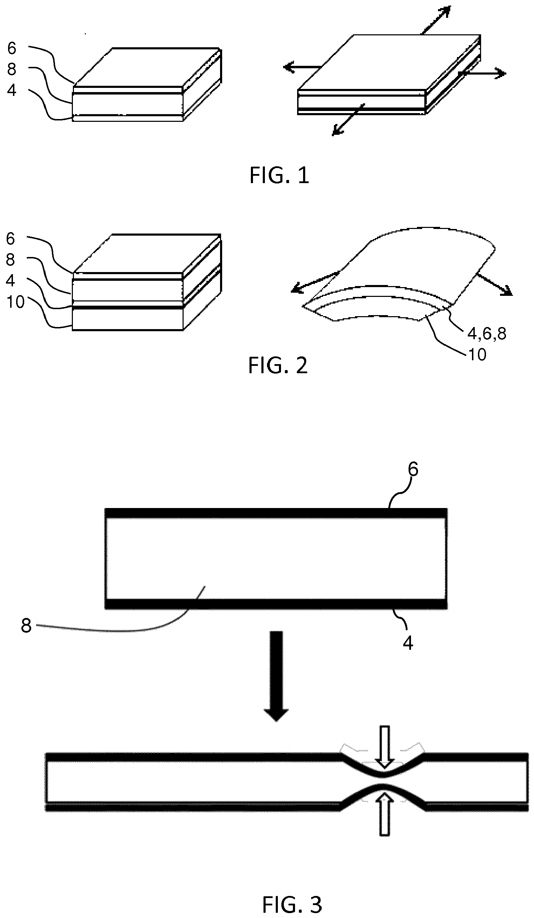

FIGs. 1 and 2 show two possible operating modes for an EAP device.

The device comprises an EAP layer 8 sandwiched between electrodes 4, 6 on opposite sides of the EAP layer 8.

FIG. 1 shows a device which is not clamped. A voltage across the electrodes 4, 6 causes the gap between the electrodes to narrow while the EAP layer 8 expands in other directions as shown.

FIG. 2 shows a device which is designed so that the expansion arises only in one direction. The device is supported by a carrier layer 10. A voltage is used to cause the EAP layer to curve or bow.

Mechanical actuators in general can be characterized in terms of a particular set of stress-strain combinations which, in their actuation performance, they are capable of realizing. This range of achievable stress-strain combinations is constrained by the inherent properties of the actuator, and possible applications for the actuator will be limited as a result.

For EAP actuators, it would be desirable to extend the range of achievable stress-strain combinations in order to broaden the potential applications for the technology. Improvement in this area has so far been achievable only through constructing complex compound actuator structures, formed of combinations of multiple EAP actuators coupled together. Such structures are complex to fabricate, have large form factor, and require significant additional driving electronics to control. This in itself restricts the range of applications for these solutions.

A common sub-division of EAP devices is into field-driven and current or charge (ion) driven EAPs. Field-driven EAPs are actuated by an electric field through direct electromechanical coupling, while the actuation mechanism for current or charge driven EAPs involves the diffusion of ions. The latter mechanism is more often found in the corresponding organic EAPs. While field driven EAPs generally are driven with voltage signals and require corresponding voltage drivers/controllers, current driven EAPs generally are driven with current or charge signals sometimes requiring current drivers. Both classes of materials have multiple family members, each having their own advantages and disadvantages.

The current driven EAPs comprise conjugated polymers (e.g. polypyrrole, poly-3,4-ethylenedioxythiophene, poly(p-phenylene sulfide), polyanilines), ionic polymer metal composites, carbon nanotube (CNT) polymer composites, ionic gels and polymer gels. These materials may be implanted as pure materials or as materials suspended in matrix materials. Matrix materials may comprise polymers.

Field-driven EAMs and EAPs are actuated by an electric field through direct electromechanical coupling. They usually require high fields (tens of mega volts per meter) but low currents. Polymer layers are usually thin to keep the driving voltage as low as possible.

A first notable subclass of field driven EAPs are piezoelectric and electrostrictive polymers. While the electromechanical performance of traditional piezoelectric polymers is limited, a breakthrough in improving this performance has led to PVDF relaxor polymers, which show spontaneous electric polarization (field driven alignment). These materials can be pre-strained for improved performance in the strained direction (pre-strain leads to better molecular alignment). Normally, metal electrodes are used since strains usually are in the moderate regime (1-5%).

Another subclass of interest of field driven EAPs is that of Dielectric Elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (e.g. 10-300%).

### SUMMARY OF THE INVENTION

A key factor in determining the degree of deformation for field-driven EAP actuators, in particular those based on dielectric elastomers, is the electrical breakdown of the EAP which occurs at the critical electric field E_{bd}. Owing to the mechanism of deformation, a 'runaway effect' can occur. Referring to FIG. 1, when the applied voltage is increased, the electrical field increases, increased electrostatic pressure between the electrodes pushes them together, the EAP contracts in thickness and expands in area. The narrower the gap between the electrodes 4, 6 becomes, the higher the electrical field becomes thus increasing the risk of electrical breakdown. It is known to persons skilled in the art that electrical shorts due to the runaway process can occur. Such electrical shorts can lead to hot spots in the EAP which may damage the polymer.

FIG. 3 schematically depicts a known EAP actuator undergoing the runaway effect. Even at electric fields smaller than E_{bd}, as the EAP becomes thinner, the risk of localized collapse of the EAP becomes greater. The unfilled arrows point towards a weak point of the polymer layer at which such a localized collapse has occurred. The electric field at the weak point becomes much higher than other regions of the EAP where collapse has not occurred, and may exceed E_{bd}. An electrical short may occur at this point and a local hot spot may result which may irreversibly damage the EAP.

In practice, the problem of the runaway effect may lead to selection of conservative operating conditions for the EAP actuator. For example, lower drive voltages may be employed leading to smaller deformations of the EAP and a smaller actuator stroke.

Selecting an EAP with sufficient stiffness (a high enough elastic modulus) that means that it cannot be compressed beyond a certain thickness may also assist to prevent the E_{bd} of the EAP being reached upon deformation. However, this also places a limit on the actuation performance in terms of the achievable stroke of the actuator. Even for such stiffer polymers, when a sufficiently high electrical field is applied, the runaway effect may nonetheless lead to exceeding of the E_{bd} of the EAP.

In addition to limitations in actuation performance, state of the art EAP actuators are also limited in achievable sensing performance. It is known that an extent of actuation of an EAP actuator can be detected through superposition of a low-amplitude AC sensing signal to the actuator driving signal. However the sensing performance using these methods is limited. In particular, the signal to noise ratio of an EAP is somewhat restrictive, and as a consequence applications requiring a high degree of precision in feedback measurements typically require additional sensors to be provided.

EAP-based actuators and methods are generally sought therefore which are capable of offering improved protection with respect to the runaway effect, improved actuation performance, and which may offer improved sensing performance.

The present invention seeks to provide an EAP-based actuator which limits or prevents the runaway effect. Protection against the runaway effect may result in the actuator being designed and/or operated such that longer actuator strokes may be achieved.

The present invention further seeks to provide a method of actuation.

The invention is defined by the independent claims. The dependent claims provide advantageous embodiments.

In accordance with an aspect, there is provided an actuator comprising: a pair of opposing electrodes; an electroactive material disposed in a gap between said pair of electrodes, the electroactive material being adapted to deform in response to application of an electrical stimulus such that the gap is narrowed; the electroactive material comprising: a deformable electroactive polymer having a first Young's modulus; and particles dispersed in the deformable electroactive polymer; wherein the particles have a second Young's modulus which is higher than the first Young's modulus, and occupy a volume fraction in a range of 13-35% of the electroactive material.

The present invention is based on the realization that by inclusion of a volume fraction of 13-35% of particles dispersed in the electroactive polymer (EAP), wherein the particles have a higher (second) Young's modulus than that of the EAP, the runaway effect may be limited or prevented.

The particles having a higher Young's modulus than the EAP may result in them not deforming to the same extent as the EAP when the electroactive material is undergoing deformation. As the gap between the electrodes narrows, the number of particles per unit of volume of the EAP may not change, but as the gap approaches the dimensions of the particles, or aggregates/clusters of the particles, a higher resistance to further deformation may occur. Above the lower limit of 13 volume% of particles in the electroactive material, the particles may mechanically restrict an extent of narrowing of the gap between the electrodes.

The particles may further provide reinforcement in the deformed layer such that the risk of localized mechanical breakdown may be lessened or eliminated.

Accordingly, the actuator may be operated using, for instance, stronger electric fields (generated by higher drive voltages) in order to generate greater deformation (longer actuator stroke) without risking the runaway effect causing the critical electric field of the electroactive material (E_{bd}) to be reached or exceeded.

The upper limit of 35 volume% of particles in the electroactive material may avoid an increase in stiffness relative to an EAP without particles of a factor of 5 or greater. A 5-fold or greater increase in stiffness may necessitate unacceptably high drive voltages risking reaching or exceeding of the E_{bd} of the electroactive material, even at gaps between the electrodes which are wider than that physically determined by the particles.

The first Young's modulus of the EAP may be in a range of 0.01 to 10 MPa.

A less stiff EAP with Young's modulus in a range of 0.01 to 10 MPa may permit greater deformation and longer actuator stroke. The runaway effect for such an EAP may not be avoided by virtue of the stiffness of the EAP material alone, but the particles may prevent the electroactive material layer thinning to an extent that may cause breach of the critical electric field (E_{bd}).

The second Young's modulus of the particles may be greater than 500 MPa.

Stiffer particles with a (second) Young's modulus greater than 500 MPa may assist in preventing localized mechanical collapse of the electroactive material.

The EAP may have a dielectric constant in a range of 1-6.

The EAP having a dielectric constant in this range is associated with a higher E_{bd} of the EAP, and thus a higher E_{bd} of the electroactive material. The E_{bd} of such an EAP may be in a range of 50-150 MV/m. Thus the actuator may be operated at higher drive voltages in order to realize greater deformation and thus longer actuator stroke.

In some embodiments, the particles may comprise dielectric particles having a dielectric constant in a range of 1-85, preferably in a range of 1-15.

By the particles comprising dielectric particles, the particles may not, or at least to a lesser extent, contribute to a decrease of the E_{bd} of the electroactive material with respect to the E_{bd} of the EAP. Accordingly, the actuator may be operated at higher drive voltages.

The particles may comprise at least one selected from polystyrene particles, polyethylene particles, fused silica particles, and titanium dioxide particles.

The particles may comprise elongate particles having an aspect ratio greater than 1.

Such elongate particles may provide an 'interlocking' effect which may occur at lower volume fractions of particles in the EAP. This interlocking may mean that lower particle volume fractions in the electroactive material may be employed relative to, for example, an actuator comprising non-elongate (e.g. spherical) particles.

In some embodiments, the particles may comprise electrically conductive particles.

The electrically conductive particles may form numerous bridges short circuiting the actuator at a certain deformation of the electroactive material. The current (originating from the capacitor load of the actuator) may be divided over these numerous bridges, thus limiting heat development per bridge to such an extent that no localized hotspots may be formed.

The particles may comprise particles of a magnetic material.

The particles of a magnetic material may be permanently magnetized particles. Clustering of the particles of a magnetic material (owing to magnetic attraction between the particles) may mean the particles may exert a more effective mechanical limit to deformation of the electroactive material at greater thicknesses of the electroactive material layer. This clustering may also mean that a concentration of the magnetic particles in the electroactive material may be lowered with respect to the case of an actuator in which, for instance, exclusively non-magnetized particles are employed.

Each of the electrodes may be deformable such they follow a deformation of the electroactive material in directions normal to a direction of said narrowing.

Each of the electrodes may comprise a plurality of flexibly coupled segments.

Flexible couplings between electrode segments may enable the electrodes to follow the deformation of the electroactive material.

In an embodiment, the actuator may further comprise a deformable dielectric layer disposed between the electroactive material and at least one of the said pair of electrodes, the deformable dielectric layer being adapted to follow the deformation of the electroactive material.

The dielectric layer may provide further protection against electrical breakdown.

According to another aspect, there is provided a device comprising the actuator as defined above, and a controller configured to control the electrical stimulus applied to the electroactive material.

The device may further comprise a sensor module configured to detect a degree of narrowing of said gap.

In an embodiment, the sensor module may be configured to generate a signal corresponding to the degree of narrowing and to transmit the signal to the controller, the controller being configured to adjust or remove the electrical stimulus in response to the signal.

According to yet another aspect, there is provided a method of actuation comprising: providing an actuator or device as defined above; and applying an electrical stimulus to the electroactive material thereby deforming the electroactive material such that the gap between the electrodes narrows towards a minimum electrode spacing; wherein said minimum electrode spacing is determined by the volume fraction of particles in the electroactive material.

### BRIEF DESCRIPTION OF THE DRAWINGS

Examples of the invention will now be described in detail with reference to the accompanying drawings, in which:
FIG. 1 shows a known electroactive polymer device which is not clamped;
FIG. 2 shows a known electroactive polymer device which is constrained by a backing layer;
FIG. 3 shows a known electroactive polymer device in an initial and a deformed state undergoing localized mechanical collapse;

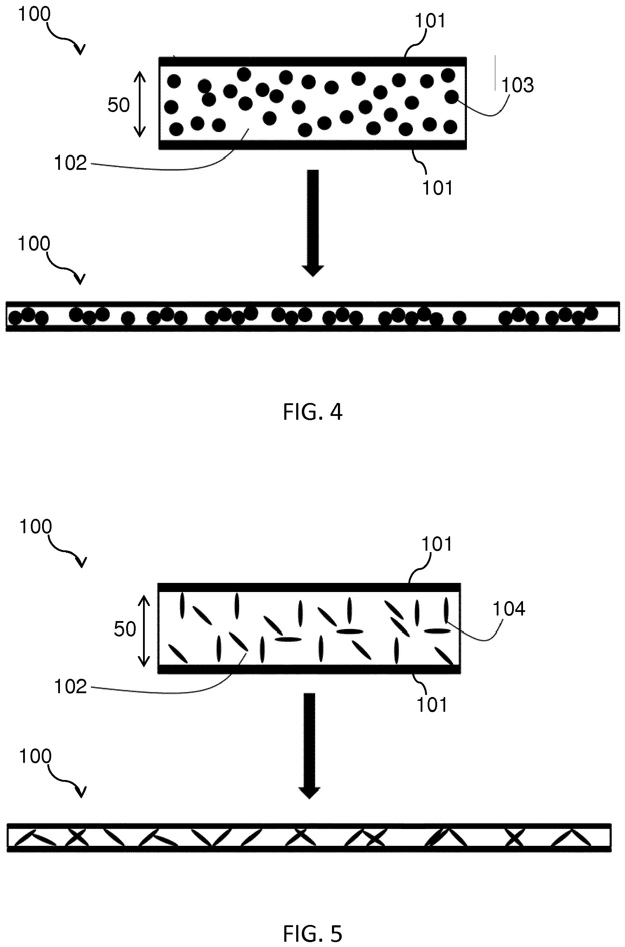

FIG. 4 schematically depicts a cross-section of an actuator in an initial and a deformed state in accordance with an embodiment;
FIG. 5 schematically depicts a cross-section of an actuator in an initial and a deformed state in accordance with another embodiment;

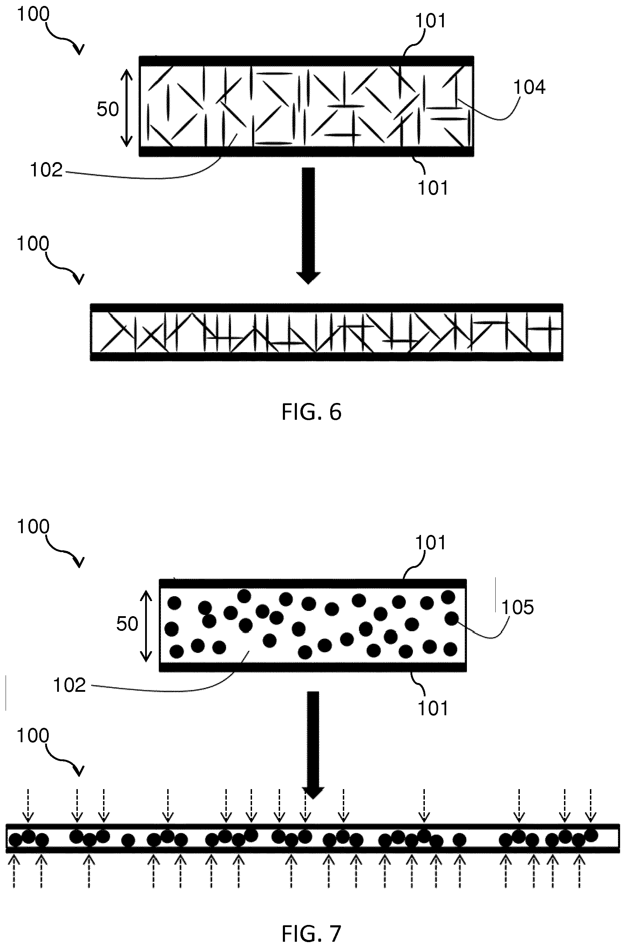

FIG. 6 schematically depicts a cross-section of an actuator in an initial and a deformed state in accordance with still another embodiment;
FIG. 7 schematically depicts a cross-section of an actuator in an initial and a deformed state in accordance with yet another embodiment;

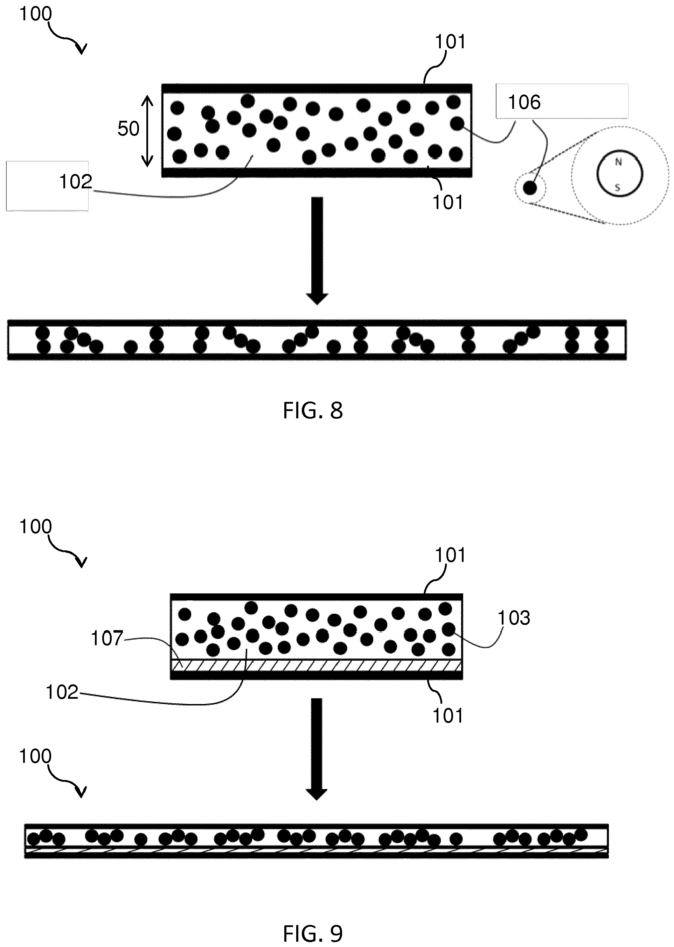

FIG. 8 schematically depicts a cross-section of an actuator in an initial and a deformed state in accordance with a further embodiment;
FIG. 9 schematically depicts a cross-section of an actuator in an initial and a deformed state in accordance with yet a further embodiment;

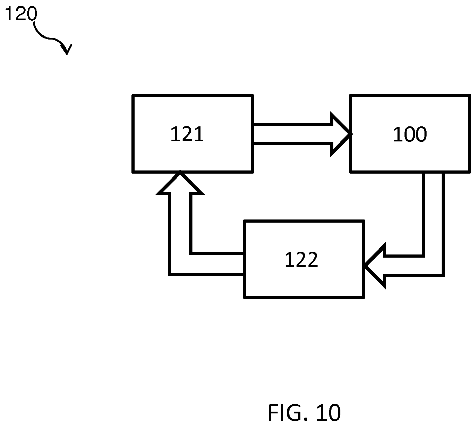

FIG. 10 shows a block diagram of a device according to an embodiment.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts, unless otherwise stated.

An actuator comprises an electroactive material disposed in a gap between electrodes. The electroactive material is capable of deforming in response to an electrical stimulus such that the gap narrows towards a minimum electrode spacing. The electroactive material comprises an electroactive polymer having a first Young's modulus, and particles dispersed in the electroactive polymer. The particles have a second Young's modulus which is higher than the first Young's modulus, and occupy a volume fraction in a range of 13-35% of the electroactive material. The particles determine the minimum electrode spacing.

FIGs. 1 and 2 show two possible operating modes for an EAP device.

The device comprises an EAP layer 8 sandwiched between electrodes 4, 6 on opposite sides of the EAP layer 8.

FIG. 1 shows a device which is not clamped. A voltage across the electrodes 4, 6 causes the gap between the electrodes to narrow while the EAP layer 8 expands in other directions as shown.

FIG. 2 shows a device which is designed so that the expansion arises only in one direction. The device is supported by a carrier layer 10. A voltage is used to cause the EAP layer to curve or bow.

Mechanical actuators in general can be characterized in terms of a particular set of stress-strain combinations which, in their actuation performance, they are capable of realizing. This range of achievable stress-strain combinations is constrained by the inherent properties of the actuator, and possible applications for the actuator will be limited as a result.

For EAP actuators, it would be desirable to extend the range of achievable stress-strain combinations in order to broaden the potential applications for the technology. Improvement in this area has so far been achievable only through constructing complex compound actuator structures, formed of combinations of multiple EAP actuators coupled together. Such structures are complex to fabricate, have large form factor, and require significant additional driving electronics to control. This in itself restricts the range of applications for these solutions.

A common sub-division of EAP devices is into field-driven and current or charge (ion) driven EAPs. Field-driven EAPs are actuated by an electric field through direct electromechanical coupling, while the actuation mechanism for current or charge driven EAPs involves the diffusion of ions. The latter mechanism is more often found in the corresponding organic EAPs. While field driven EAPs generally are driven with voltage signals and require corresponding voltage drivers/controllers, current driven EAPs generally are driven with current or charge signals sometimes requiring current drivers. Both classes of materials have multiple family members, each having their own advantages and disadvantages.

The current driven EAPs comprise conjugated polymers (e.g. polypyrrole, poly-3,4-ethylenedioxythiophene, poly(p-phenylene sulfide), polyanilines), ionic polymer metal composites, carbon nanotube (CNT) polymer composites, ionic gels and polymer gels. These materials may be implanted as pure materials or as materials suspended in matrix materials. Matrix materials may comprise polymers.

Field-driven EAMs and EAPs are actuated by an electric field through direct electromechanical coupling. They usually require high fields (tens of mega volts per meter) but low currents. Polymer layers are usually thin to keep the driving voltage as low as possible.

A first notable subclass of field driven EAPs are piezoelectric and electrostrictive polymers. While the electromechanical performance of traditional piezoelectric polymers is limited, a breakthrough in improving this performance has led to PVDF relaxor polymers, which show spontaneous electric polarization (field driven alignment). These materials can be pre-strained for improved performance in the strained direction (pre-strain leads to better molecular alignment). Normally, metal electrodes are used since strains usually are in the moderate regime (1-5%).

Another subclass of interest of field driven EAPs is that of Dielectric Elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (e.g. 10-300%).

FIG. 4 schematically depicts a cross-section of an actuator 100 according to an embodiment. FIG. 4 represents the actuator 100 undergoing a deformation: the top pane of FIG. 4 depicts an initial un-deformed state of the actuator 100, while the bottom pane of FIG. 4 depicts a deformed state of the actuator 100. An electrical stimulus may be applied by, for example, applying a drive voltage across the electrodes 101. The drive voltage may be provided by any suitable voltage driver/controller (not shown in FIG. 4). The un-deformed/initial state may be the state of the actuator 100 when no drive voltage is applied.

Upon application of the drive voltage, the gap 50 between the electrodes 101 may become narrower due to an electrostatic pressure pushing the electrodes 101 together. An electroactive material may be sandwiched between the electrodes 101. The electroactive material may comprise an electroactive polymer (EAP) 102 and particles 103 dispersed in the EAP 102. The EAP 102 may be deformable such that it may be compressed in a direction between the electrodes 101 as they are pushed together. The volume of the EAP 102 may remain quasi-constant during deformation such that the compression is accompanied by expansion of the EAP 102 in directions normal to the direction of compression. Accordingly, the electrical stimulus is converted into mechanical movement.

It is noted that the actuation behaviour depicted in FIGs. 4-9 may correspond to that of an unclamped actuator 100 (i.e. as depicted in FIG. 1). However, this should not be regarded as limiting the present scope to unclamped actuators; other actuator designs are known to which the present teaching may be applied. It is further noted at this point that the cross-sectional nature of FIGs. 4-9 means that only expansion of the EAP 102 in opposing directions along a single axis normal to the direction of compression is depicted. However, this should not be interpreted that such expansion does not take place in directions along an axis perpendicular to the illustrated axis (also normal to the direction of compression).

The electric field (E) is related to the drive voltage (V) and the separation (d) between the electrodes 101 by the relation: E = V/d. As the gap 50 between the electrodes 101 narrows, d decreases and E increases. The increased electric field then results in further narrowing of the gap 50 (and compression of the electroactive material). As previously described, this 'runaway effect' may result in the electric field increasing to or beyond the electrical breakdown of the electroactive material which occurs at the critical electric field E_{bd}. Thinning of the electroactive material may also lead to localised mechanical collapse in prior art actuators as previously described with reference to FIG. 3.

The particles 103 dispersed in the EAP 102 may have a higher Young's modulus than the EAP 102 with the result that the particles 103 may not deform to the same extent as the EAP 102 when it is undergoing deformation. The particles 103 may occupy a volume fraction of 13-35% of the electroactive material.

For example, the particles 103 may occupy a volume fraction of 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35% of the electroactive material.

The present invention is based on the realization that above the lower limit 13 volume%, the particles 103 may mechanically restrict the extent of narrowing of the gap 50 between the electrodes 101. The number of particles 103 per unit of volume of the EAP 102 may not change upon deformation, but as the gap 50 narrows and approaches the dimensions of the particles 103, or aggregates/clusters of the particles 103, a higher resistance to further deformation may occur, as schematically depicted in FIG. 4.

Thus the particles 103 may have the effect of providing a mechanical 'stop' for the runaway effect. The particles 103 may also increase the stiffness of the electroactive material, and hence decrease the actuation effect, which in turn may be increased again by, for example, increasing the drive voltage.

At the upper limit of 35 volume% of particles 103 in the electroactive material, the increase in stiffness with respect to an EAP without particles dispersed therein may be by a factor of ca. 2-5 (see, for instance, J.S. Bergstrom and M.C. Boyce, Mechanical Behavior of Particle Filled Elastomers, Rubber Chemistry and Technology, volume 72, pages 633-656, 1999). To compensate for this increase in stiffness, the drive voltage may be increased by a factor of 2.25 (for a 5-fold increase in stiffness; this increase corresponding to the square root of 5, comparing electrostatic force and force to induce a certain strain shows that strain is linearly dependent on the young modulus and quadratic dependent on the voltage).

This may mean that a drive voltage must increase from, for instance, 200 V (a typical value) to 450 V in order to deliver the same actuation effect. Above this voltage the electroactive polymer may be very likely to breakdown even when the electrodes 101 cannot come any closer due to the mechanical 'stop' provided by the particles 103. This therefore determines the upper limit of 35 volume% of particles in the electroactive material.

Thus the upper limit of 35 volume% of particles 103 in the electroactive material is determined by avoidance of an increase in stiffness of a factor of 5 or greater (which would necessitate unacceptably high drive voltages). The reliability of the mechanical 'stop' functions of the particles 103 may be less relevant at this end of the volume fraction range because the inter-particle distances are low.

At the lower limit of 13 volume% of particles 103 in the electroactive material, the increase in stiffness with respect to an EAP without particles dispersed therein may be by a factor of ca. 0.7-1.8. To compensate for this, the drive voltage may be increased by a factor of 1.4 (for a 1.8-fold increase in stiffness; this increase corresponding to the square root of 1.8). Accordingly, in order to deliver the same actuation effect, the drive voltage may be increased from, for instance, 200 V to 280 V. There may be no breakdown due to the increase in drive voltage not being sufficient to approach the E_{bd} of the electroactive material. In this case mechanical 'stop' provided by the particles 103 may work very well.

This volume fraction may not be decreased lower than 13 volume% considering that the distance between particles to a first order approximation must be in the order of few times the particle diameter. Whilst exact description of the shape change of the EAP 102 between particles 103 may be complex, the inventors have found that a separation between particles 103 corresponding to two particle diameters (which may coincide with 13 volume%) may lead to the requisite breakdown protection since the particles do also increase the average stiffness of the actuator.

The particles 103 may further provide reinforcement in the deformed electroactive material such that the risk of localized mechanical breakdown may be lessened or eliminated.

In practice, the problem of the runaway effect may lead to conservative operating conditions for prior art EAP actuators. For example, lower drive voltages may be employed leading to smaller deformations of the EAP and a smaller actuator stroke. However, in the case of the actuator 100 of FIG. 4, higher drive voltages may be employed owing to the role of the particles 103 in preventing the gap 50 from becoming too narrow, thus ensuring that E_{bd} may not be reached; the particles 103 further lessening the risk of localized mechanical breakdown as previously described. Accordingly, the present actuator 100 may be operated so as to achieve greater deformation of the electroactive material and longer actuator stroke.

An upper limit of 35 volume% of particles 103 in the electroactive material may ensure that the EAP 102 concentration may be sufficient for adequate deforming of the electroactive material.

According to an embodiment, the (first) Young's modulus of the EAP 102 may be in a range of 0.01 to 10 MPa. For the avoidance of doubt, it is noted that the Young's moduli referred to herein are determined using standard testing techniques described in detail by Carpi et al. in Smart Mater. Struct. 24 (2015) 105025, and referred to in 'Electromechanically Active Polymers: A Concise Reference' (edited by F. Carpi).

As previously described for prior art actuator devices, a higher Young's modulus EAP 102 may be necessary in order to avoid excessive deformation and concomitant breach of E_{bd}, thereby also limiting the achievable stroke length of such a device. However, owing to the inclusion of at least 13 volume% of particles 103 in the electroactive material which physically prevents excessive thinning and localized mechanical breakdown, a less stiff EAP 102 with a Young's modulus in a range of 0.01 to 10 MPa may be employed in the actuator 100. Thus a longer actuator stroke may also be attained by virtue of a less stiff EAP 102 (with a Young's modulus in the range of 0.01 to 10 MPa).

The electroactive material layer may, while the actuator 100 is in an un-deformed/initial state, be any suitable thickness such as between 1 and 50 µm, such as between 1 and 10 µm.

The EAP 102 may be included in the electroactive material in an amount greater than 50 volume%, such as greater than 65 volume% of the electroactive material.

In an embodiment, the EAP 102 may have a dielectric constant in a range of 1-6. It is noted that the measured value for the dielectric constant may vary slightly depending on the frequency employed for measurement. For the avoidance of doubt, the frequency employed for the determination of the dielectric constant for the materials described herein (including the EAP 102, particles 103 and dielectric layer 107 (vide infra)) is 1 kHz.

The dielectric constant may be determined using standard testing techniques described in detail by Carpi et al. in Smart Mater. Struct. 24 (2015) 105025, and referred to in 'Electromechanically Active Polymers: A Concise Reference' (edited by F. Carpi).

A dielectric constant in the range of 1-6 may be associated with an E_{bd} of the EAP 102 in a range of 50-150 MV/m. Such a relatively high E_{bd} may mean that the actuator 100 may be operated at relatively higher drive voltages in order to realize greater deformation and longer actuator stroke.

Suitable EAP materials which may be included in the EAP 102 of the actuator 100 as well-known per se. Such EAP materials may include, but are not limited to: piezoelectric polymers, ferroelectric polymers (comprising a spontaneous permanent polarization (dipole moment)), electrostrictive polymers (comprising a polarization (dipole moment) when driven, but not when not driven), relaxor ferroelectric polymers (such as PVDF-based relaxor polymers or polyurethanes), dielectric elastomers, liquid crystal elastomers. Other examples include electrostrictive graft polymers, electrostrictive paper, electrets, electroviscoelastic elastomers and liquid crystal elastomers.

The lack of a spontaneous polarization means that electrostrictive polymers display little or no hysteretic loss even at very high frequencies of operation. The advantages are however gained at the expense of temperature stability. Relaxors operate best in situations where the temperature can be stabilized to within approximately 10 °C. This may seem extremely limiting at first glance, but given that electrostrictors excel at high frequencies and very low driving fields, then the applications tend to be in specialized microactuators. Temperature stabilization of such small devices is relatively simple and often presents only a minor problem in the overall design and development process.

Relaxor ferroelectric materials may have an electrostrictive constant that is high enough for good practical use, i.e. advantageous for simultaneous sensing and actuation functions. Relaxor ferroelectric materials are non-ferroelectric when zero driving field (i.e. voltage) is applied to them, but become ferroelectric during driving. Hence there is no electromechanical coupling present in the material at non-driving. The electromechanical coupling becomes non-zero when a drive signal is applied and can be measured through applying the small amplitude high frequency signal on top of the drive signal. Relaxor ferroelectric materials, moreover, benefit from a unique combination of high electromechanical coupling at non-zero drive signal and good actuation characteristics.

In preferred examples, the EAP 102 may include soft dielectric elastomers, such as acrylates, polyurethanes, silicones, diene elastomers etc. Such elastomers may, for instance, have a Young's modulus in the range of 0.01 to 10 MPa.

Examples of such elastomers include: silicone-based elastomers such as Silicone Nusil CF19-2186 (Young's modulus = 1.0 MPa; Dielectric Constant (1 kHz) = 2.8), Silicone Dow Corning HS3 (Young's modulus (following centrifuging to remove particulates) = 0.125; Dielectric Constant (1 kHz) = 2.8), Silicone Dow Corning Sylgard 186 (Young's modulus = 0.7 MPa; Dielectric Constant (1 kHz) = 2.8); polybutadiene elastomers such as Polybutadiene (PBD) available from Aldrich (Young's modulus = 1.7 MPa; Dielectric Constant (1 kHz) = 4.0); Isoprene Natural Rubber Latex (Young's modulus = 0.85 MPa; Dielectric Constant (1 kHz) = 2.7). Such elastomers may thus simultaneously have a (first) Young's modulus in a range of 0.01-10MPa, and a dielectric constant in a range 1-6.

Alternatively or additionally, the EAP 102 may include PVDF-based relaxor ferroelectric-based polymers. Such polymers may show spontaneous electric polarization and may be pre-strained for improved performance in the strained direction. They may include any one of the following: Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

In non-limiting examples, the electroactive material may additionally include inorganic electroactive materials. For example, the electroactive material may include inorganic relaxor ferroelectric materials such as lead magnesium niobate (PMN), lead magnesium niobate-lead titanate (PMN-PT) and lead lanthanum zirconate titanate (PLZT). Other such inorganic electroactive materials are known in the art.

As shown in FIG. 4, the electroactive material may be sandwiched between two electrodes 101. In alternative non-limiting examples, the actuator 100 may comprise more than two electrodes 101.

The electrodes 101 may be adhered onto a surface of the electroactive material using any suitable means, such as by using an adhesive. Alternatively the electrodes 101 may be embedded in the electroactive material. The electrodes 101 may, for example, be patterned or non-patterned.

In an embodiment, the electrodes 101 may be deformable such they follow a deformation of the electroactive material in directions normal to a direction of said narrowing. In other words, the electrodes 101 may follow the deformation of the electroactive material. The degree of deformability of the electrodes 101 may be selected according to the deformability (stress-strain properties) of the electroactive material such that the electrodes 101 may not inhibit the deforming of the electroactive material.

In alternative non-limiting examples, the electrodes 101 may themselves at least partially inhibit deformation of the electroactive material layer.

Given that the present actuator 100 may be operated so as to achieve longer actuator stroke (owing to the in-built protection against the runaway effect provided by the particles), electrodes 101 may be selected for a high-strain regime of the electroactive material. The electrodes 101 may therefore comprise, for example, carbon black based oils, gels or elastomers.

Conductive materials suitable for the electrodes 101 are also well-known per se. Such materials may, for example, be selected from the group consisting of thin metal films, such as gold, copper, or aluminium or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminium coating.

In an embodiment, the electrodes 101 may each comprise a plurality of flexibly coupled segments, thus enabling the electrodes 101 to follow the deformation of the electroactive material.

In some arrangements of the actuator 100, the electrodes 101 may be on each side of an electroactive material layer. In an alternative non-limiting example, an electrode layer 101 may be provided on one side only of an electroactive material layer for example using interdigitated comb electrodes.

FIG. 4 further schematically depicts particles 103 dispersed in the EAP 102.

In an embodiment, the particles 103 may have a (second) Young's modulus greater than 500 MPa. Stiffer particles 103 with a (second) Young's modulus greater than 500 MPa may assist in preventing localized mechanical collapse of the electroactive material.

In an embodiment, the EAP 102 may have a dielectric constant in a range of 1-6.

The EAP 102 having a dielectric constant in this range is associated with a higher E_{bd}. The E_{bd} of such materials may be in a range of 50-150 MV/m. Thus the actuator 100 may be operated at higher drive voltages in order to realize greater deformation and longer actuator stroke.

In some embodiments, the particles 103 may comprise dielectric particles having a dielectric constant in a range of 1-85, preferably in a range of 1-15. In some embodiments, it may be desirable to select particles 103 with a dielectric constant as close to that of the EAP 102 as possible (i.e. as low as possible). In this way, the particles 103 may not, or to a lesser extent, contribute to a decrease in the E_{bd} of the electroactive material with respect to the E_{bd} of the EAP 102. Accordingly, the actuator 100 may be operated at higher drive voltages.

The particles 103 may have any suitable maximum diameter which may be based on a minimum gap 50 between the electrodes 101, and thus also on the E_{bd} of the EAP 102. In non-limiting examples, a suitable maximum diameter of the particles 103 may be, for instance, in the range 0.5-10 µm.

In the context of the present application, the term 'maximum diameter' refers to the maximum cross-sectional dimension of the particles 103, and is not intended to limit the shape of the particles 103 to spherical particles. The particles 103 may have any suitable shape, e.g. may be spherical, platelets, flakes, nanoparticles including core-shell nanoparticles, nanowires, nanorods, nanotubes and so on. The 'maximum diameter' may be measured, for instance, using microscopy techniques as are well-known to the skilled person.

In an embodiment, the particles 103 may comprise at least one selected from polystyrene particles, polyethylene particles, fused silica particles, and titanium dioxide particles.

The particles 103 may, for example, consist entirely of a material (e.g. polystyrene, polyethylene, silica, titanium dioxide) or may, in other non-limiting examples, comprise a core-shell structure in which the shell is formed of a material (e.g. polystyrene, polyethylene, silica, titanium dioxide), and the core may be formed of another material.

In an embodiment, the particles 103 may comprise fused silica particles. Such particles may have a relative dielectric constant of 3.8 (typical), an electrical breakdown threshold of 30 MV/m, and an elasticity modulus in the order of 73 GPa.

Accordingly the fused silica particles may have a (second) Young's modulus which may be greater than that of the EAP 102. The fused silica particles may also have a dielectric constant which is close to that of the EAP 102.

In a non-limiting example the actuator 100 may comprise an electroactive material with an un-deformed/initial thickness of 3 µm. The electroactive material may be subjected to an electric field of 18 MV/m; the electrical field may reach 27 MV/m when the gap 50 between the electrodes 101 is narrowed to 2 µm. When, for instance, fused silica particles are used with a maximum diameter of 2 µm, the electrical field to which the particles are subjected will thus be 27 MV/m which is lower than the electrical breakdown threshold of the particles (30 MV/m).

In another embodiment, the particles 103 may comprise polystyrene particles. Such particles may have a relative dielectric constant of 2.5 (typical), an electrical breakdown threshold of 20 MV/m, and an elasticity modulus in the order of 3 GPa.

Accordingly the polystyrene particles may have a (second) Young's modulus which may be greater than that of the EAP 102. The polystyrene particles may also have a dielectric constant which is close to that of the EAP 102.

In another non-limiting example, the actuator 100 may comprise an electroactive material with an un-deformed/initial thickness of 3 µm. The electroactive material may be subjected to an electric field of 10 MV/m; the electrical field may reach 15 MV/m when the gap 50 between the electrodes 101 is narrowed to 2 µm. When, for instance, polystyrene particles are used with a maximum diameter of 2 µm, the electrical field to which the particles are subjected will thus be 15 MV/m which is lower than the electrical breakdown threshold of the particles (20 MV/m).

In still another embodiment, the particles 103 may comprise polyethylene particles, such as high density polyethylene particles. Such particles may have a relative dielectric constant of 2.25, an electrical breakdown threshold of up to 160 MV/m, and an elasticity modulus in the order of 0.8 GPa (for high density polyethylene).

Accordingly the high density polyethylene particles may have a (second) Young's modulus which may be greater than that of the EAP 102. The polyethylene particles may also have a dielectric constant which is close to that of the EAP 102.

In another non-limiting example, the actuator 100 may comprise an electroactive material with an un-deformed/initial thickness of 3 µm. The electroactive material may be subjected to an electric field of 100 MV/m; the electrical field may reach 150 MV/m when the gap 50 between the electrodes 101 is narrowed to 2 µm. When, for instance, polyethylene particles are used with a maximum diameter of 2 µm, the electrical field to which the particles are subjected will thus be 150 MV/m which is lower than the electrical breakdown threshold of the particles (160 MV/m).

In yet another embodiment, the particles 103 may comprise titanium dioxide particles. Such particles may have a relative dielectric constant in the range of 10-85, an electrical breakdown threshold of 2-12 MV/m, and an elasticity modulus in the order of ca. 230-288 GPa.

Accordingly the titanium dioxide particles may have a (second) Young's modulus which may be significantly greater than that of the EAP 102. The titanium dioxide particles may also have a dielectric constant which is close to, or somewhat higher than, that of the EAP 102.

In another non-limiting example, the actuator 100 may comprise an electroactive material with an un-deformed/initial thickness of 3 µm. The electroactive material may be subjected to an electric field of 0.67 MV/m; the electrical field may reach 1 MV/m when the gap 50 between the electrodes 101 is narrowed to 2 µm. When, for instance, titanium dioxide particles are used with a maximum diameter of 2 µm, the electrical field to which the particles are subjected will thus be 1 MV/m which is lower than the electrical breakdown threshold of the particles (2-12 MV/m).

Referring to FIG. 5, the particles may in an embodiment comprise elongate particles 104 having an aspect ratio greater than 1. In other words, the particles may comprise particles 104 having a non-circularly symmetric cross-section with a length dimension greater than a width dimension. The elongate particles 104 may, for example, comprise platelets, flakes, nanowires, nanorods, nanotubes etc.

As previously described, the particles 103 may result in the actuator 100 being able to achieve a longer stroke by permitting use of a less stiff EAP 102 and/or a higher drive voltage (by providing protection against the runaway effect). In this embodiment in which the particles may comprise elongate particles 104 with an aspect ratio greater than 1, an 'interlocking' of particles 104 may occur at lower volume fractions of particles in the EAP 102. This interlocking, as depicted in FIG. 5, may mean that lower particle volume fractions may be employed to provide the requisite mechanical restraint to excessive narrowing of the gap 50 between the electrodes 101, in comparison to, for example, an actuator 100 comprising non-elongate particles (such as spherical particles).

Particles with an aspect ratio of greater than 1, such as needle-like particles, may form a less dense random packing then spherical particles. Without wishing to be bound by any particular theory, this may be rationalized by considering that the orientation of a high aspect ratio particle, such as a needle, may be fixed when it is incorporated in 'a haystack' of other high aspect ratio particles. Any attractive interactions between such particles may further amplify this effect.

FIG. 6 schematically depicts an actuator 100 wherein the particles comprise elongate particles 104 having a higher aspect ratio with respect to the elongate particles 104 depicted in FIG. 5.

The degree of interlocking of the elongate particles 104 may depend on both the particle concentration and the aspect ratio. The high aspect ratio (and thinness) of the particles 103, may mean that the requisite volume fraction (at least 13 volume% with respect to the EAP 102) and desired interlocking may be attained but a total mass of the particles may not increase, for example, relative to that of the actuator 100 depicted in FIG. 5.

FIG. 7 schematically depicts an actuator 100 wherein the particles comprise electrically conductive particles 105. The top pane of FIG. 7 shows the actuator 100 in an un-deformed/initial state. When an electrical stimulus (e.g. an electric field resulting from an applied drive voltage being applied across the electrodes 101) is applied to the electroactive material, the thickness of the electroactive material decreases and consequently the density of particles 105 over the thickness increases creating mechanical resistance to further decrease of the thickness of the EAP 102 (as shown in the bottom pane of FIG. 7). Owing to the particles 105 being electrically conductive, the particles 105 may form various bridging chains between the electrodes 101 thereby creating an electrical short per bridge. These are identified by the hatched arrows in FIG. 7.

Conductive particles with higher electrical conductivity may result in a relatively high current in a single bridging chain when an electrical short occurs. However, a hotspot may be prevented due to the many bridging chains. On the other hand, for conductive particles with lower electrical conductivity, the current per bridging chain will be less, so even less heat development may result when an electrical short occurs. In the latter case, the drop in voltage may take more time, so detection of the electrical short may consequently occur somewhat later. However, the lower degree of heat development may mean that later detection may not be critical. The electrically conductive particles 105 may be any suitable type of electrically conductive particles such as carbon particles, carbon composite particles, ceramic particles, metal particles, metal alloy particles, composite metal particles and conductive metal oxide particles, such as indium tin oxide particles, or combinations thereof.

The conductive particles 105 may be dispersed in the EAP 102 with or without nonconductive or dielectric particles. In a non-limiting example, conductive particles 105 may be dispersed in the EAP 102 without any non-conductive/dielectric particles such that the electrically conductive particles themselves may be responsible for mechanically limiting the deformation of the electroactive material. Alternatively, both electrically conductive and nonconductive/dielectric particles may be dispersed in the EAP 102.

An electrical short in prior art (non-composite) EAP-based actuators may often occur at one point (see FIG. 3), thus resulting in all current passing through this point and creating a hotspot which may destroy the actuator. However, in this embodiment since there may be numerous bridges short circuiting the actuator 100, the current (originating from the capacitor load) may be divided over these numerous bridges, thus limiting heat development per bridge to such an extent that no localized hotspots may be formed.

FIG. 8 schematically depicts an actuator 100 wherein the particles comprise magnetic particles 106. The inset of FIG. 8 shows an enlargement of a magnetic particle 106; all the magnetic particles 106 may be magnetized in the same direction.

The magnetic particles 106 may be permanently magnetized particles. An 'interlocking' of the magnetic particles 106 may thus be caused by the attractive forces between the magnetic particles 106. Moreover, magnetic particles 106 with parallel oriented magnetization may repel each other promoting formation of magnetic particle clusters. The distance between the clusters may be larger than the distance between the particles 103 as shown in, for instance, FIG. 4 since the size of the cluster may be larger than the diameter of the (non-magnetic) particles 103 (schematically depicted in FIG. 4).

The cluster size and concentration may be sufficient such that the distance between the clusters may be small enough to prevent mechanical collapse of the actuator 100 between the clusters.

A more effective mechanical limit to deformation of the electroactive material may be reached at greater thicknesses of the electroactive material layer. This clustering may also mean that a concentration of the magnetic particles 106 (e.g. permanent magnetized particles) may be lowered with respect to the case of an actuator 100 in which, for instance, exclusively non-magnetized particles are employed.

When the drive voltage is cut, the electroactive material may reflow to its initial (un-deformed) state. A degree to which the magnetic particles 106 may return to their original positions may depend on the force caused by the reflow and on the attractive magnetic forces holding the clusters together. Even if the clusters will remain fully intact, they may prevent the runaway process during subsequent actuation cycles.

Such magnetic particles 106 are well-known to person skilled in the art. Magnetic particles 106 may, for instance, comprise ferromagnetic materials such as ferrites, and metals such as SmCo or NdFeB. Other suitable materials for forming magnetic particles 106 will be immediately apparent to the skilled reader.

In a non-limiting example, so-called core-shell magnetic particles may be employed wherein the magnetic particles 106 may comprise a core of superparamagnetic material and a shell made of polymer. The shell may, for example, comprise elastically deformable polymer droplets having a viscosity lower than that of the EAP 102.

The core-shell particles may be dispersed throughout the EAP 102, each core-shell particle containing a collection of one or more (rigid) magnetic particles 106. Upon electrical stimulation (e.g. by application of a drive voltage), the polymer droplets may follow the induced deformation of the EAP 102 through elastically changing their shape, but do not migrate through the polymer matrix due to their relatively lower viscosity. The EAP 102 and the polymer droplets may be immiscible.

The effect of providing the magnetic particles encased within polymer droplets may be the mitigation of resistance against deformation of the EAP 102. This is because upon deformation of the EAP 102, the polymer droplets are capable of deforming without applying significant resistance to the surrounding EAP 102. This is in contrast to a system in which magnetic particles are directly embedded within the EAP 102. In this case, the magnetic particles 106 do exert a partial resistance against deformation of the EAP 102, since EAP molecules must migrate (shear) along the surface of the particles 106. Shearing against the droplets does also occur, but since the viscosity of these droplets is significantly lower than that of the EAP 102, the partial resistance against the deformation may be less.

The magnetic particles 106 may be dispersed in the EAP 102 with or without non-magnetic particles. The latter may, for example, provide greater resistance against deformation than, for instance, core-shell magnetic particles.

The particles 103 may be dispersed in the EAP 102 using any suitable technique. Techniques of providing polymer-particle composite materials are well-known per se, and may, for instance, comprise compounding, solution mixing, etc.

The requisite volume fraction of the particles 103 in the electroactive material may be achieved by controlling the mass of the particles 103, the mass of the EAP 102, and the mass of any additional components included in the electroactive material. As will be readily recognized by the skilled person, this requires knowledge of the density of the particles 103, the density of the EAP 102, and the density of any additional components.

In a non-limiting example, a compounding technique may be employed whereby the particles 103 and EAP 102 are combined via a mixer or a mill. Compounding may, for instance, provide control over the volume fraction of particles 103 in the EAP 102 (and thus in the electroactive material) which may lead to control over different properties of the composite: particles in general increase stiffness but this may be compensated by using a softer EAP 102 (i.e. with a lower (first) Young's modulus).

In alternative non-limiting examples, the EAP 102 may be dissolved in a solvent. The solvent may subsequently be partially evaporated affording a viscous solution. The particles 103 may be mixed into the viscous solution. The solution comprising both the EAP 102 and particles 103 may then be used in a solvent casting process to prepare the electroactive material.

Alternatively, a (soft) EAP 102, such as a silicone-based dielectric elastomer, may be produced by a casting process involving mixing at least two reacting components, one of the components further comprising a catalyst for catalyzing a reaction between the two reacting components. Particles 103 may be contained in at least one of the components.

Silicone elastomers may, for instance, be prepared by this technique. One of the components may contain a Pt or peroxide curing catalyst. The different components may be mixed in a high speed mixer. In the same process, the particles 103 can be added or the particles 103 may already be premixed in one or both components. The particles 103 may in general be applied in a solvent which evaporates during processing. After or during mixing in a high speed mixer in general vacuum is applied to remove air (and or solvents). After this the mixture may be casted and cured. Curing temperature and time depends on the polymer grade but is typically around 80°C for 10 minutes. Most particles are compatible with silicones as long as they do not deactivate the catalyst (for instance sulphur containing materials). Peroxide curing silicones are less sensitive.

In other examples, mixing can also occur in an injection molding process, with reaction of the two components in the mold. Silicones, for instance, may be injection molded (liquid silicone rubbers, LSR). The two reacting components may be injected on a screw, after passing a (static) mixer, of the LSR injection molding machine. The particles 103 may be premixed in one or both components. The material is transported by a cold screw and injected into a hot mold where it cures fast depending on temperature. As the LSR has very low viscosity very thin sections can be realized. Typical curing temperatures are close to 180°C and curing times around 30 seconds to one minute.

Besides casting and injection molding a number of other shaping technologies are available to produce an electroactive material thin film. Examples are extrusion (foils and profiles), rolling of foils, lamination and rolling of multilayers, doctor blade film casting, spin coating and screen printing, or additive manufacturing (e.g. 3D printing).

Turning to FIG. 9, the actuator 100 according to an embodiment is schematically depicted; the actuator 100 further comprising a deformable dielectric layer 107 disposed between the electroactive material and an electrode 101. The deformable dielectric layer 107 may be adapted to follow the deformation of the electroactive material. The dielectric layer may be used in actuators 100 according to any of the herein embodiments.

The dielectric layer 107 may assist to prevent electrical breakdown, particularly when higher dielectric constant particles 103 may be dispersed in an EAP 102 having a lower dielectric constant with respect to the particles 103.

It should be noted that when particles 103 are used with a significantly different dielectric constant with respect to the EAP 102, high local fields may occur (due to the difference in dielectric constant between the particles 103 and the EAP 102) which can introduce alterations which may decrease the lifetime of the actuator 100. In such scenarios, electrical breakdown may be prevented by the dielectric layer 107.

The dielectric layer may comprise any suitable material which may be dielectric (e.g. with a dielectric constant in a range of 1-6), and deformable (e.g. with a Young's modulus in a range 0.01-10 MPa). The dielectric polymer 107 may, for example, comprise one or more selected from acrylates, polyurethanes, silicones, diene elastomers etc.

In non-limiting examples, the actuator 100 may comprise additional layers (i.e. in addition to the electrodes 101, the electroactive material, and, in some embodiments, a dielectric layer 107). Such additional layers may, for instance, comprise additional polymer layers and may be used to adapt the electrical or mechanical behavior of the actuator 100. For example, additional passive layers may be provided for influencing the behaviour of the electroactive layer in response to an applied drive signal.

The materials for the different layers will be selected for example taking account of the elastic moduli (Young's moduli) of the different layers.

In non-limiting examples, a substrate may be part of the actuation arrangement. It may be attached to the ensemble of electroactive material and electrodes 101, between the electrodes 101 or to a surface of an electrode 101 opposing an inner surface which may be in contact with the electroactive material layer.

According to another aspect, there is provided a device 120 comprising the actuator 100 according to any of the herein embodiments, and a controller 121 configured to control the electrical stimulus (e.g. the drive voltage) applied to the electroactive material. A block diagram of a device 120 according to an embodiment is shown in FIG. 10.

According to an embodiment the device 120 may further comprise a sensor module 122 configured to detect a degree of narrowing of said gap.

The sensor module 122 may be configured to generate a signal corresponding to said degree of narrowing and to transmit said signal to the controller 121, the controller 121 being configured to adjust or remove the electrical stimulus in response to said signal.

The sensor module 122 may comprise any suitable sensing means which are well-known per se. For example, a well-known means of sensing involves superposition of a low-amplitude AC sensing signal to the actuator driving signal; the AC signal permitting the capacitance of the actuator 100 to be determined (and thus the separation).

In a non-limiting example, an actuator 100 as depicted in FIG. 7 may be employed in the device 120 comprising a sensor module 122. Upon deformation to an extent that the 'multi-bridge' short circuit of the actuator 100 may occur, the sensor module 122 may sense the short circuit and may transmit a signal to the controller 121 which may, for instance, cut the drive voltage. The conductive particles 105 may make for improved signal to noise ratio in terms of the point at which the limit of deformation of the electroactive material layer is reached.

Accordingly, a means for protecting the actuator 100 is achieved via the dispersion of conducting particles 105 in the EAP 102, combined with a suitable sensor module 122 and controller 121.

In another non-limiting example, an actuator 100 as depicted in FIG. 8 may be employed in the device 120 comprising a sensor module 122. The sensor module 122 may, for instance, comprise a magnetic field sensor, adapted to detect the strength of a magnetic field within, or proximal to, at least a section of the actuator 100. The magnetic field within the electroactive material may change upon deformation, e.g. as the magnetic particles 106 form clusters. Accordingly the sensor module 122 may generate a signal based on a change in the shape of the actuator 100. Such a signal may be transmitted to the controller 121 which may respond by adjusting the electrical stimulus (e.g. the drive voltage) if necessary.

The invention can be applied in many EAP and photoactive polymer applications, including examples where a passive matrix array of actuators is of interest.

In many applications the main function of the product relies on the (local) manipulation of human tissue, or the actuation of tissue contacting interfaces. In such applications EAP actuators for example provide unique benefits mainly because of the small form factor, the flexibility and the high energy density. Hence EAP's and photoactive polymers can be easily integrated in soft, 3D-shaped and / or miniature products and interfaces. Examples of such applications are:
Skin cosmetic treatments such as skin actuation devices in the form of a responsive polymer based skin patches which apply a constant or cyclic stretch to the skin in order to tension the skin or to reduce wrinkles;
Respiratory devices with a patient interface mask which has a responsive polymer-based active cushion or seal, to provide an alternating normal pressure to the skin which reduces or prevents facial red marks;
Electric shavers with an adaptive shaving head. The height of the skin contacting surfaces can be adjusted using responsive polymer actuators in order to influence the balance between closeness and irritation;
Oral cleaning devices such as an air floss with a dynamic nozzle actuator to improve the reach of the spray, especially in the spaces between the teeth. Alternatively, toothbrushes may be provided with activated tufts;
Consumer electronics devices or touch panels which provide local haptic feedback via an array of responsive polymer transducers which is integrated in or near the user interface;
Catheters with a steerable tip to enable easy navigation in tortuous blood vessels.

Another category of relevant application which benefits from such actuators relates to the modification of light. Optical elements such as lenses, reflective surfaces, gratings etc. can be made adaptive by shape or position adaptation using these actuators. Here one benefit of EAPs for example is lower power consumption.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. An actuator (100), comprising:
a pair of electrodes (101);
an electroactive material disposed in a gap between said pair of electrodes, the electroactive material being adapted to deform in response to application of an electrical stimulus such that said gap is narrowed; the electroactive material comprising:
a deformable electroactive polymer (102) having a first Young's modulus; and
particles (103) dispersed in the deformable electroactive polymer;
wherein the particles have a second Young's modulus which is higher than the first Young's modulus, and occupy a volume fraction in a range of 13-35% of said electroactive material.

2. The actuator (100) of claim 1, wherein the first Young's modulus is in a range of 0.01 to 10 MPa.

3. The actuator (100) of claim 1 or 2, wherein the second Young's modulus is greater than 500 MPa.

4. The actuator (100) of any of claims 1-3, wherein the deformable electroactive polymer (102) has a dielectric constant in a range of 1-6.

5. The actuator (100) of any of claims 1-4, wherein the particles (103) comprise dielectric particles having a dielectric constant in a range of 1-85, preferably in a range of 1-15.

6. The actuator (100) of any of claims 1-5, wherein the particles (103) comprise at least one selected from polystyrene particles, polyethylene particles, fused silica particles, and titanium dioxide particles.

7. The actuator (100) of any of claims 1-6, wherein the particles comprise elongate particles (104) having an aspect ratio greater than 1.

8. The actuator (100) of any of claims 1-7, wherein the particles comprise electrically conductive particles (105).

9. The actuator (100) of any of claims 1-8, wherein the particles comprise particles of a magnetic material (106).

10. The actuator (100) of any of claims 1-9, wherein the each of the electrodes (101) is deformable such they follow a deformation of the electroactive material in directions normal to a direction of said narrowing.

11. The actuator (100) of any of claims 1-10, wherein each of the electrodes (101) comprises a plurality of flexibly coupled segments.

12. The actuator (100) of any of claims 1-11, further comprising a deformable dielectric layer (107) disposed between the electroactive material and at least one of the said pair of electrodes (101), said deformable dielectric layer being adapted to follow the deformation of the electroactive material.

13. A device (120) comprising the actuator (100) of any of claims 1-12, and a controller (121) configured to control the electrical stimulus applied to the electroactive material.

14. The device (120) of claim 13, wherein the device further comprises a sensor module (122) configured to detect a degree of narrowing of said gap; optionally wherein the sensor module is configured to generate a signal corresponding to said degree of narrowing and to transmit said signal to the controller (121), the controller being configured to adjust or remove the electrical stimulus in response to said signal.

15. A method of actuation comprising:
providing an actuator (100) of any of claims 1-12 or a device (120) of claim 13 or 14; and
applying an electrical stimulus to the electroactive material, thereby deforming the electroactive material such that the gap between the electrodes (101) narrows towards a minimum electrode spacing;
wherein said minimum electrode spacing is determined by the volume fraction of particles (103) in the electroactive material.
